# EUROPEAN PATENT APPLICATION

(11) **EP 4 517 827 A1**
(43) Date of publication of application: **05.03.2025**
(21) Application number: 23193787.1
(22) Date of filing: 28.08.2023
(51) Int. Cl.: H01L 29/06, H01L 29/872, H01L 29/78, H01L 29/808, H01L 29/16, H01L 29/20

(54) **A SEMICONDUCTOR DEVICE HAVING AN IMPROVED TERMINATION AREA, AS WELL AS A CORRESPONDING METHOD AND POWER DEVICE**

(71) Applicant: Nexperia B.V., 6534 AB Nijmegen (NL)
(72) Inventor: Dai, Tianxiang, Hamburg (DE); Urresti Ibanez, Jesus Roberto, 22529 Hamburg (DE); El-Zammar, Georgio, Hamburg (DE); Mazzillo, Massimo Cataldo, Hamburg (DE); Habenicht, Sönke, 22529 Hamburg (DE)
(74) Representative: Pjanovic, Ilija

(57) **Abstract**

A semiconductor device, comprising a semiconductor body comprising a semiconductor substrate and an epitaxial layer formed on the semiconductor substrate, said epitaxial layer being of the first conductivity type, and wherein an active area and a termination area adjacent the active area are arranged in the epitaxial layer, wherein the termination area comprises a Junction Termination Extension, JTE, layer of the second conductivity type formed in the epitaxial layer extending laterally from the active area thereby forming a JTE region, a plurality of laterally spaced apart regions, said regions being of the second conductivity type and being higher doped than said JTE layer, wherein a first part of said plurality of laterally spaced apart regions are formed within said JTE region such that said first part of said plurality of laterally spaced apart regions penetrate said JTE layer, and a second part of said plurality of laterally spaced apart regions are formed outside said JTE region such that said second part of said plurality of laterally spaced apart regions do not penetrate said JTE layer.

## Description

### Technical field

The present disclosure generally relates to the field of semiconductor devices and, more specifically, to the edge termination of an active area of a semiconductor device.

### Background

Edge termination is an important part of power devices. Most of planar and trench power devices are based on one or several PN-type junctions. When the active part of the junction ends on the lateral side of the device, a very high electric field may appear under reverse voltage biasing, due to junction curvature or trench corners.

A periphery protection, called edge termination may be required. Reliable and robust high voltage devices may need effective edge termination structures to protect the device periphery, so that blocking values close to the ideal 1D avalanche voltage value can be achieved.

Several physical limitations make SiC edge terminations quite complex to design. The main limitation is the low diffusion coefficients of dopant atoms inside the semiconductor. Deep junction, for example > 1µm, may be difficult to implement and lateral dopants diffusion may be very limited. Moreover, the higher interface traps level observed in the SiC/passivation interface compared to Silicon may also affect the efficiency of the standard Si terminations architectures in the SiC power devices.

Charges may accumulate at the interface, generating breakdown voltage instabilities and early failures, especially with temperature. Finally, the termination design may also be relevant to be able to reach high avalanche ruggedness to comply with applications prone to unclamped inductive switching, UIS.

P+ floating guard rings (Kao Rings) implemented in a n-doped substrate have been proposed in the past, among all the possible termination structures integrated on SiC power devices. The width and distance of P rings increase when the distance to active area increases, i.e. towards the end of the diode or saw lane.

In standard implementations, P+ floating rings are integrated by implanting P-type impurities, for example Al, onto an N doped epitaxial layer. However, the limited junction depth achievable on SiC and high crystal damage arising from the use of high dose implants, necessary for the poor activation of the P dopant push to find suitable alternatives for floating ring designs compatible with the definition of the P doped area by epitaxy and not only by implantation.

On one hand, in fact, the process limitations described above put some limits for proper termination design and on the other hand the high surface damage produced by the implantation process combined to passivation charges can produce breakdown voltage instabilities and early failures when the device operates under high stressing conditions, for example high humidity, temperature or voltage.

Furthermore, highly doped channel stopper regions around the saw lane area may be used to avoid the depletion and/or inversion of the semiconductor, due to passivation charges. If not properly designed, some leakage paths can occur at the interface between passivation and termination, ultimately leading to reduced blocking voltage and sometimes early failures. The termination design would undoubtedly benefit from the integration of additional features preventing layer inversion in the termination area.

### Summary

It is an object of the present disclosure to provide for a semiconductor device that has an improved termination area.

It would further be advantageous to achieve a corresponding method and power device.

In a first aspect of the present disclosure, there is provided a semiconductor device, comprising:
a semiconductor body comprising a semiconductor substrate and an epitaxial layer formed on the semiconductor substrate, said epitaxial layer being of the first conductivity type, and wherein an active area and a termination area adjacent to the active area are arranged in the epitaxial layer, wherein the termination area comprises:
- a Junction Termination Extension, JTE, layer of the second conductivity type formed in the epitaxial layer extending laterally from the active area thereby forming a JTE region;
- a plurality of laterally spaced apart regions, said regions being of the second conductivity type and being higher doped than said JTE layer, wherein:
   - a first part of said plurality of laterally spaced apart regions are formed within said JTE region such that said first part of said plurality of laterally spaced apart regions penetrate said JTE layer,
   - a second part of said plurality of laterally spaced apart regions are formed outside said JTE region such that said second part of said plurality of laterally spaced apart regions do not penetrate said JTE layer.

The present disclosure is directed to the concept that a JTE layer is provided in the termination area, and that a plurality of spaced apart regions are provided in the termination area as well.

A first part of the plurality of spaced apart regions penetrates the JTE layer. From a lateral perspective, the first part of the plurality of spaced apart regions is provided within the region in which the JTE layer is provided.

In the context of the present disclosure, the wording penetrates entails that the spaced apart regions extend into the JTE layer but are, not necessarily, going through the whole JTE layer. The spaced apart regions may be shallower compared to the JTE layer.

In an example, the depth of the spaced apart regions is about 50% - 150% of the depth of the JTE layer.

The second part of the plurality of spaced apart regions is provided in a region where the JTE layer is not provided. Thus, the JTE layer stops at a certain lateral distance from the active area. The second part of the plurality of spaced apart regions are provided from this certain lateral distance and further away from the active area.

The second part of the plurality of spaced apart regions may have the same dimensions compart to the first part of the plurality of spaced apart regions, i.e. the same width and depth parameters.

Each of the plurality of spaced apart regions may enclose, observed from a top view of the semiconductor device, the active area. This may mean that the regions may loop around the active area, for example in the shape of a circle rectangle, ellipse, or anything alike.

The active area of a semiconductor device contains the functional components, such as transistors, diodes, or other functional elements, where the desired electrical or electronic functions take place. On the other hand, the termination area is the portion of the device that lies beyond the active area and serves specific purposes related to device performance and protection.

The primary function of the termination area is to provide a controlled transition from the active area to the surrounding environment. It helps manage electric field distribution and prevent undesirable effects, such as electrical breakdown or leakage, that can occur at the edges or periphery of the active area.

In high-voltage semiconductor devices, such as SiC-based power devices, the termination area is particularly important. It is designed to distribute the electric field more evenly and reduce the concentration of electric field lines at the edges. This helps prevent voltage crowding or field-induced breakdown, enhancing the breakdown voltage and overall device performance.

The present disclosure defines a plurality of spaced apart regions, wherein for some of those regions, i.e. the first part, the JTE layer is provided in between and for other regions, i.e. the second part, the JTE layer is not provided in between.

The JTE layer is thus discontinuous as it is interrupted by the first part of the plurality of spaced apart regions.

It is noted that the average doping of the spaced apart regions may be higher that 1e18 cm^-3. This indicates that the spaced apart regions are highly doped and are not just another JTE layer with slightly higher doping.

In the following description, a first zone is used to indicate the lateral part of the termination area in which the JTE area is provided. The second zone is used to indicate the lateral part of the termination area in which the JTE area is not provided and wherein the second part of the spaced apart regions is provided.

The advantage of the first zone is that the stability and/or robustness against negative surface charges that may be induced on the top of the drift / epitaxial region may be enhanced. It further improves the process window for the first region, i.e. the one closest to the active region. This is also shown in the figures and elucidated in more detail there.

The advantage of the second zone is that it is tailored to an almost ideal situation wherein there are no surface charges.

Following the above, the semiconductor device in accordance with the present disclosure improves the stability and/or robustness performance of the termination region, especially with the presence of surface charges induced in the manufacturing process.

In an example, the termination area further comprises:
- a second JTE layer formed in the epitaxial layer and extending laterally from the region of the second part of the plurality of laterally spaced apart regions which is furthest away from said active area.

The present example defines that there is provided a second JTE layer at the lateral end of the plurality of spaced apart regions.

In the following description, a third region is used for indicating the lateral part of the termination region where the second JTE layer is provided.

The third region is used to enhance the stability and/or robustness against positive surface charges induced on top of the drift / epitaxial region.

In a further example, either one of:
- a number of regions in said first part equals the number of regions in said second part;
- a number of regions in said second part is more than a number of regions in said first part.

The inventors have found that the number of regions in the first part and the second part may not be the same. If the second JTE layer is not provided, then it may be necessary to have more regions in the second part compared to the number of regions in the first part. If a second JTE layer is provided, then the same number of regions may be provided in the first part and the second part.

In a further example, the termination area further comprises:
- a Current Spreading Layer, CSL, of the first conductivity type, wherein a doping concentration of said CSL is higher than a doping concentration of said epitaxial layer, and wherein said CSL is provided laterally adjacent to said JTE region such that at least one of said second part of said plurality of laterally spaced apart regions penetrate said CSL layer.

A Current Spreading Layer, CSL, may be a component used in semiconductor devices to improve the distribution of electric current across the active area of the device. It is designed to mitigate the effects of current crowding, which can lead to uneven current flow and localized heating within the device.

The CSL layer in the termination area may be created at the same process step as the CSL layer in the active area. The CSL layer may thus be of the same depth, and the same doping concentration as the one in the active area. As such, there is no need for an additional method / process step to create such a CSL.

In an example, a depth of said CSL in said semiconductor body substantially equals a depth of said JTE region in said semiconductor body.

In a further example, the CSL layer comprises any of:
- a unform doping profile;
- a vertically graded doping profile.

A gradient profile may be preferred, for example having an increased doping from the top surface to bulk for a better trade-off for the on-state performance of the semiconductor device.

In a further example, the semiconductor device is any of:
- a Silicon Carbide based power device;
- a Silicon Carbide based Metal Oxide Semiconductor, MOS, Field Effect Transistor, FET;
- A Silicon Carbide based Junction Field-Effect Transistor;
- A Silicon Carbide based Schottky Barrier, SB, diode;
- A Silicon Carbide based Junction Barrier Schottky, JBS, diode;
- A Silicon Carbide based Merged PiN Schottky Diode.

In yet another example, the semiconductor body comprises any of Silicon Carbide, SiC, and Gallium Nitride, GaN.

In an even further example, the plurality of laterally spaced apart regions are floating.

Floating means that the first regions are not connected to any specific electrical potential or reference point. In other words, it is not electrically tied to any voltage source or ground.

For example, a P-type floating ring can act as a voltage isolation structure. By leaving it floating, it may help electrically isolate or separate different regions or components within the semiconductor device, preventing undesired electrical coupling or interference. This isolation can be important to ensure proper device functionality and avoid unwanted electrical interactions.

The floating ring may be designed to shape or control the electric field distribution within the terminal area. Its floating nature allows it to modify the electric field gradients or patterns, influencing the electrical behavior of the device. This can help optimize performance, enhance breakdown voltage, reduce electric field crowding, or mitigate other electric field-related effects.

In another example, the active area further comprises:
- a well of said second conductivity type, provided in said epitaxial layer, and extending from a top surface of said semiconductor body into said epitaxial layer with a penetration depth;
wherein each of said plurality of spaced apart regions extend from said top surface of said semiconductor body into said epitaxial layer with said penetration depth.

The advantage of this particular example is that the process does not need an additional process step to obtain the spaced apart regions. The spaced apart regions may be provided in the termination area in one go, i.e. along with obtaining the well(s) in the active area.

In a further example, any of:
- a lateral distance between said active region and a region of said first part of said plurality of laterally spaced apart regions closest to said active region is at most 1,5 µm;
- a lateral distance between any of said plurality of laterally spaced apart regions is between 1 - 4 µm.

In yet another example, a depth of said JTE region is smaller than a depth of said plurality of spaced apart regions.

In a further example, a distance between adjacent regions of said plurality of laterally spaced apart regions is either equal or increase for regions further away from said active area.

In an example, each of said plurality of spaced apart regions are uniformly doped.

In another example, the first conductivity type corresponds to N-type and said second conductivity type corresponds to P-type.

In yet another example, the device further comprises a passivation stack comprising Silicon Nitride and/or Silicon Dioxide.

This makes the design tolerate to effective surface charge up to +/-5e12cm^-2.

In a second aspect of the present disclosure, there is provided a method of manufacturing a semiconductor device in accordance with any of the previous examples, wherein said method comprises the steps of:
- providing said Junction Termination Extension, JTE, layer of the second conductivity type in the epitaxial layer extending laterally from the active area thereby forming a JTE region;
- providing said plurality of laterally spaced apart regions, said regions being of the second conductivity type and being higher doped than said JTE layer, wherein said step of providing comprises:
- providing said first part of said plurality of laterally spaced apart regions are within said JTE region such that said first part of said plurality of laterally spaced apart regions penetrate said JTE layer,
- providing said second part of said plurality of laterally spaced apart regions are outside said JTE region such that said second part of said plurality of laterally spaced apart regions do not penetrate said JTE layer.

It is noted that the advantages as explained with reference to the first aspect of the present disclosure, being the semiconductor device, are also applicable to the second aspect of the present disclosure, being the method of manufacturing such a semiconductor device.

In a third aspect of the present disclosure, there is provided a power device comprising a semiconductor device in accordance with any of the previous examples.

The present disclosure is described in conjunction with the appended figures. It is emphasized that, in accordance with the standard practice in the industry, various features are not drawn to scale. In fact, the dimensions of the various features may be arbitrarily increased or reduced for clarity of discussion.

In the appended figures, similar components and/or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.

The above and other aspects of the disclosure will be apparent from and elucidated with reference to the examples described hereinafter.

### Brief description of the drawings

Fig. 1 discloses an example of a semiconductor device in accordance with the present disclosure;
Fig. 2 discloses another example of a semiconductor device in accordance with the present disclosure;
Fig. 3 discloses a further example of a semiconductor device in accordance with the present disclosure;
Fig. 4 discloses an example of a semiconductor device in accordance with the present disclosure;
Fig. 5 discloses another example of a semiconductor device in accordance with the present disclosure;
Fig. 6 discloses yet another example of a semiconductor device in accordance with the present disclosure.

### Detailed Description

It is noted that in the description of the figures, same reference numerals refer to the same or similar components performing a same or essentially similar function.

A more detailed description is made with reference to particular examples, some of which are illustrated in the appended drawings, such that the manner in which the features of the present disclosure may be understood in more detail. It is noted that the drawings only illustrate typical examples and are therefore not to be considered to limit the scope of the subject matter of the claims. The drawings are incorporated for facilitating an understanding of the disclosure and are thus not necessarily drawn to scale. Advantages of the subject matter as claimed will become apparent to those skilled in the art upon reading the description in conjunction with the accompanying drawings.

The ensuing description above provides preferred exemplary embodiment(s) only, and is not intended to limit the scope, applicability or configuration of the disclosure. Rather, the ensuing description of the preferred exemplary embodiment(s) will provide those skilled in the art with an enabling description for implementing a preferred exemplary embodiment of the disclosure, it being understood that various changes may be made in the function and arrangement of elements, including combinations of features from different embodiments, without departing from the scope of the disclosure.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, electromagnetic, or a combination thereof. Additionally, the words "herein," "above," "below," and words of similar import, when used in this application, refer to this application as a whole and not to any particular portions of this application. Where the context permits, words in the Detailed Description using the singular or plural number may also include the plural or singular number respectively. The word "or," in reference to a list of two or more items, covers all of the following interpretations of the word: any of the items in the list, all of the items in the list, and any combination of the items in the list.

These and other changes can be made to the technology in light of the following detailed description. While the description describes certain examples of the technology, and describes the best mode contemplated, no matter how detailed the description appears, the technology can be practiced in many ways. Details of the system may vary considerably in its specific implementation, while still being encompassed by the technology disclosed herein. As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the Detailed Description section explicitly defines such terms. Accordingly, the actual scope of the technology encompasses not only the disclosed examples, but also all equivalent ways of practicing or implementing the technology under the claims.

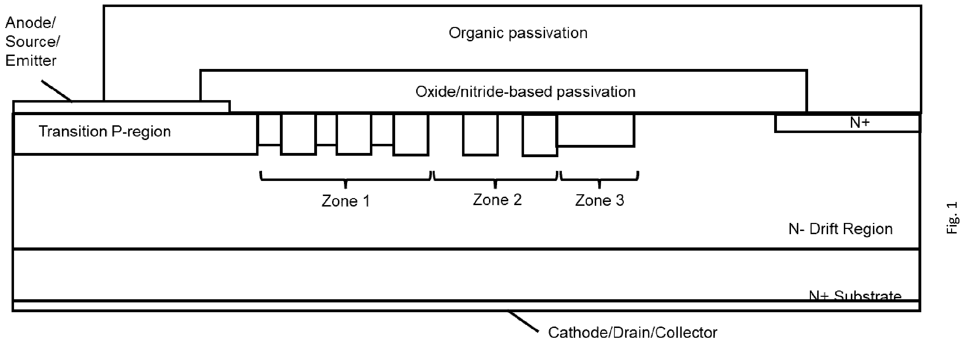

Fig. 1 discloses an example of a semiconductor device in accordance with the present disclosure.

Figure 1 discloses a semiconductor device comprising a semiconductor body comprising a semiconductor substrate and an epitaxial layer formed on the semiconductor substrate, said epitaxial layer being of the first conductivity type, and wherein an active area and a termination area adjacent to the active area are arranged in the epitaxial layer.

An epitaxial layer may refer to a layer of semiconductor material that is grown or deposited on top of a substrate or a base material. Epitaxy, the process of growing this layer, may involve the controlled deposition of atoms or molecules onto a substrate, allowing them to align with the existing crystal lattice structure of the substrate.

The purpose of growing an epitaxial layer is to create a semiconductor material with specific properties that are different from the substrate material. For example, in the context of integrated circuits, an epitaxial layer can be used to introduce regions with different doping concentrations or material compositions, allowing the creation of different transistor structures or other device components.

In the example shown in figure 1, three different zones may be identified: The first zone, the second zone and the third zone. All of these three zones are located within the termination area. The active area is the area wherein the functional components are formed.

The termination area comprises a Junction Termination Extension, JTE, layer of the second conductivity type. The JTE layer is formed in the epitaxial layer and extends laterally from the active area thereby forming a JTE region. This is indicated by the first zone in figure 1.

The termination area further comprises a plurality of laterally spaced apart regions, wherein the regions are of the second conductivity type and are higher doped than the JTE layer.

In accordance with the present disclosure, the laterally spaced apart regions are provided in the first zone and the second zone. That is, a first part of the plurality of laterally spaced apart regions are formed within said JTE region such that said first part of said plurality of laterally spaced apart regions penetrate said JTE layer. A second of said plurality of laterally spaced apart regions are formed outside said JTE region such that said second part of said plurality of laterally spaced apart regions do not penetrate said JTE layer.

The first zone thus comprises a combination of laterally spaced apart regions and the JTE layer, while the second zone does not comprise the JTE layer.

A second JTE layer is formed in the epitaxial layer and extends laterally from the region of the second part of the plurality of laterally spaced apart regions which is furthest away from said active area. This is indicated by the third zone in the semiconductor shown in figure 1.

The figures also show two passivation layers, namely the organic passivation layer and the oxide/nitride based passivation layer.

In the context of semiconductors, passivation refers to the process of applying protective layers on the surface of a semiconductor device to prevent degradation and improve its long-term reliability. The termination area is a region that may need protection as it's exposed to various environmental factors and potential sources of damage.

An organic passivation layer is usually made of polymers or organic materials. Its primary function is to provide mechanical protection against physical damage, as well as to serve as a moisture barrier. Moisture and other contaminants can negatively affect the performance and reliability of semiconductor devices. The organic passivation layer acts as a protective shield, preventing moisture and other harmful substances from reaching the underlying semiconductor materials.

The oxide or nitride-based passivation layer is typically made of materials such as silicon dioxide, SiO2, or silicon nitride, Si3N4. Its primary purpose is to provide additional protection against moisture, chemical exposure, and other environmental factors. Silicon dioxide and silicon nitride are known for their excellent dielectric properties, making them effective insulators that can help prevent electrical leakage and interference between neighboring components on the semiconductor chip.

The figures also show a channel stopper. A channel stopper refers to a structure or technique used to prevent the unwanted formation of conducting paths, i.e. channels, between different components or regions on a semiconductor substrate or wafer.

The primary purpose of a channel stopper is to isolate different regions on the semiconductor substrate, especially the active regions where transistors or other electronic components are fabricated. By preventing unintended channel formation, channel stoppers help maintain the integrity and proper functioning of individual components on the chip. Uncontrolled channels between components can lead to leakage currents, increased power consumption, and other undesirable effects that degrade the performance of the integrated circuit.

A channel stopper is typically created by introducing a heavily doped region of the same polarity, for example N-type, compared to the main substrate doping. This region effectively creates a barrier that hinders the formation of channels between neighboring active regions. The channel stopper is usually placed beneath an insulating layer, such as silicon dioxide, to further isolate it from other components.

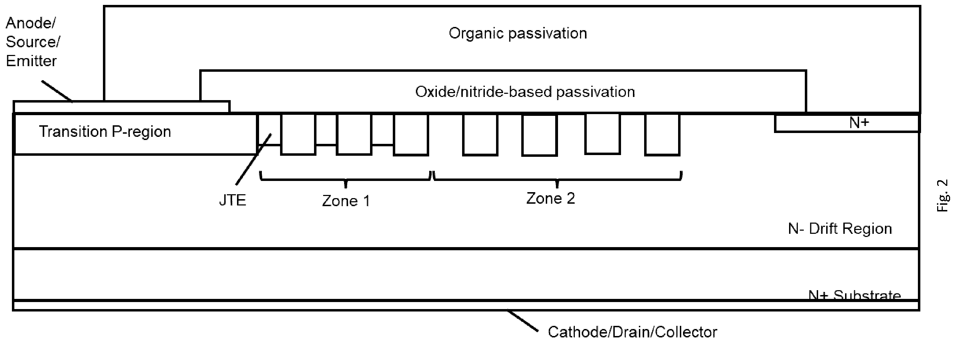

Fig. 2 discloses another example of a semiconductor device in accordance with the present disclosure.

It is noted that the semiconductor shown in figure 2 does not have the second JTE layer. The inventors have found that the third zone may be omitted in that the second JTE layer is not provided. In this particular case, the number of laterally spaced apart regions in the second zone may be increased to compensate for the lack of the second JTE layer.

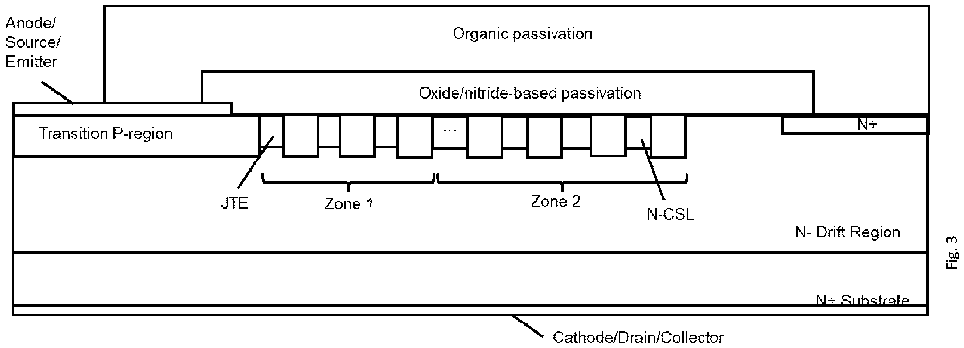

Fig. 3 discloses a further example of a semiconductor device in accordance with the present disclosure.

In this particular case, a Current Spreading Layer, CSL, is provided in between the laterally spaced apart regions provided in the second zone. This improves the on-state performance of the device in the active area. The CSL in the termination is used to improve the positive surface charge tolerance. If there is positive surface charge induced in the termination area, the CSL with opposite polarity of carrier can help to compensate a bit.

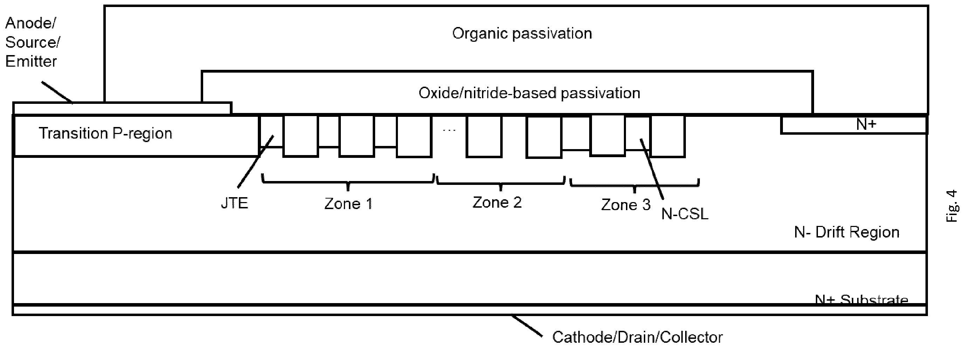

Figure 4 discloses a semiconductor device that is a variant of the one shown in figure 3.

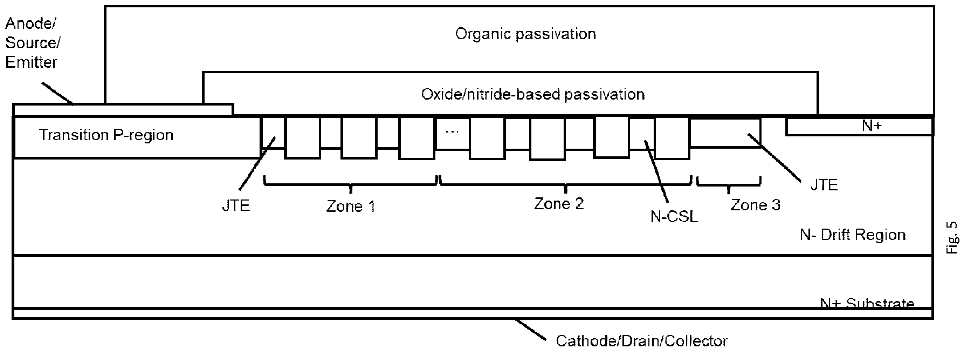

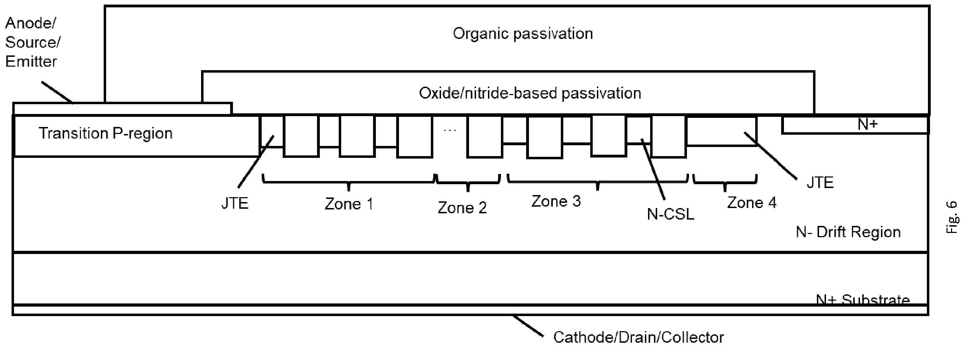

Figures 5 and 6 shown further examples of semiconductor devices in accordance with the present disclosure.

To reduce the number of claims, certain aspects of the technology are presented below in certain claim forms, but the applicant contemplates the various aspects of the technology in any number of claim forms. For example, while some aspect of the technology may be recited as a computer-readable medium claim, other aspects may likewise be embodied as a computer-readable medium claim, or in other forms, such as being embodied in a means-plus-function claim.

In the description above, for the purposes of explanation, numerous specific details are set forth in order to provide a thorough understanding of implementations of the disclosed technology. It will be apparent, however, to one skilled in the art that embodiments of the disclosed technology may be practiced without some of these specific details.

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope thereof.

## Claims

1. A semiconductor device, comprising:
a semiconductor body comprising a semiconductor substrate and an epitaxial layer formed on the semiconductor substrate, said epitaxial layer being of the first conductivity type, and wherein an active area and a termination area adjacent to the active area are arranged in the epitaxial layer, wherein the termination area comprises:
- a Junction Termination Extension, JTE, layer of the second conductivity type formed in the epitaxial layer extending laterally from the active area thereby forming a JTE region;
- a plurality of laterally spaced apart regions, said regions being of the second conductivity type and being higher doped than said JTE layer, wherein:
- a first part of said plurality of laterally spaced apart regions are formed within said JTE region such that said first part of said plurality of laterally spaced apart regions penetrate said JTE layer,
- a second part of said plurality of laterally spaced apart regions are formed outside said JTE region such that said second part of said plurality of laterally spaced apart regions do not penetrate said JTE layer.

2. A semiconductor device in accordance with claim 1, wherein said termination area further comprises:
- a second JTE layer formed in the epitaxial layer and extending laterally from the region of the second part of the plurality of laterally spaced apart regions which is furthest away from said active area.

3. A semiconductor device in accordance with any of the previous claims, wherein either one of:
- a number of regions in said first part equals the number of regions in said second part;
- a number of regions in said second part is more than a number of regions in said first part.

4. A semiconductor device in accordance with any of the previous claims, wherein the termination area further comprises:
- a Current Spreading Layer, CSL, of the first conductivity type, wherein a doping concentration of said CSL is higher than a doping concentration of said epitaxial layer, and wherein said CSL is provided laterally adjacent to said JTE region such that at least one of said second part of said plurality of laterally spaced apart regions penetrate said CSL layer.

5. A semiconductor device in accordance with claim 4, wherein said CSL layer comprises any of:
- a unform doping profile;
- a vertically graded doping profile.

6. A semiconductor device in accordance with any of the previous claims, wherein said device is any of:
- a Silicon Carbide based power device;
- a Silicon Carbide based Metal Oxide Semiconductor, MOS, Field Effect Transistor, FET;
- A Silicon Carbide based Junction Field-Effect Transistor;
- A Silicon Carbide based Schottky Barrier, SB, diode;
- A Silicon Carbide based Junction Barrier Schottky, JBS, diode;
- A Silicon Carbide based Merged PiN Schottky Diode.

7. A semiconductor device in accordance with any of the claims 1-6, wherein said semiconductor body comprises any of Silicon Carbide, SiC, and Gallium Nitride, GaN.

8. A semiconductor device in accordance with any of the previous claims, wherein said plurality of laterally spaced apart regions are floating.

9. A semiconductor device in accordance with any of the previous claims, wherein said active area further comprises:
- a well of said second conductivity type, provided in said epitaxial layer, and extending from a top surface of said semiconductor body into said epitaxial layer with a penetration depth;
wherein each of said plurality of spaced apart regions extend from said top surface of said semiconductor body into said epitaxial layer with said penetration depth.

10. A semiconductor device in accordance with any of the previous claims, wherein any of:
- a width between said active region and a region of said first part of said plurality of laterally spaced apart regions closest to said active region is at most 1,5 µm;
- a width of any of said plurality of laterally spaced apart regions is between 1 - 4 µm.

11. A semiconductor device in accordance with any of the previous claims, wherein a depth of said JTE region is smaller than a depth of said plurality of spaced apart regions.

12. A semiconductor device in accordance with any of the previous claims, wherein a distance between adjacent regions of said plurality of laterally spaced apart regions is either equal or increase for regions further away from said active area.

13. A semiconductor device in accordance with any of the previous claims, wherein each of said plurality of spaced apart regions are uniformly doped.

14. A method of manufacturing a semiconductor device in accordance with any of the previous claims, wherein said method comprises the steps of:
- providing said Junction Termination Extension, JTE, layer of the second conductivity type in the epitaxial layer extending laterally from the active area thereby forming a JTE region;
- providing said plurality of laterally spaced apart regions, said regions being of the second conductivity type and being higher doped than said JTE layer, wherein said step of providing comprises:
- providing said first part of said plurality of laterally spaced apart regions are within said JTE region such that said first part of said plurality of laterally spaced apart regions penetrate said JTE layer,
- providing said second part of said plurality of laterally spaced apart regions are outside said JTE region such that said second part of said plurality of laterally spaced apart regions do not penetrate said JTE layer.

15. A power device comprising a semiconductor device in accordance with any of the claims 1 - 14.
